# EUROPEAN PATENT SPECIFICATION

(11) **EP 1 456 850 B1**
(45) Date of publication and mention of the grant of the patent: **09.11.2005**
(21) Application number: 02782024.0
(22) Date of filing: 29.11.2002
(51) Int. Cl.: G11C 11/22, H01L 27/13

(54) **FOLDED MEMORY LAYERS**
KLAPPSPEICHERSCHICHTEN
COUCHES DE MEMOIRE PLIEES

(30) Priority: 30.11.2001 NO 20015871
(43) Date of publication of application: 15.09.2004
(73) Proprietor: Thin Film Electronics ASA, 0124 Oslo (NO)
(72) Inventor: GUDESEN, Hans, Gude, B-1000 Brussels (BE); NORDAL, Per-Erik, N-1387 Asker (NO)
(74) Representative: Ahmad, Sheikh Shakeel
(86) International application number: PCT/NO2002/000458
(87) International publication number: WO 2003/046924

(56) References cited:
- WO-A2-99/12170
- WO-A2-99/63527
- US-A- 5 969 380

## Description

The present invention concerns a ferroelectric or electret volumetric memory device, wherein a ferroelectric or electret memory material is provided in sandwich between first and second electrode layers respectively comprising first and second parallel stripe-like electrodes forming word lines and bit lines of a matrix-addressable memory array, wherein word lines and bit lines of the array are oriented substantially at right angles to each other, wherein memory cells are defined in volumes of memory material sandwiched between respective crossings word lines and bit lines, and wherein a plurality of memory arrays are provided in at least one stack such that the at least one stack of memory arrays realizes the memory device with a volumetric configuration.

In a wider sense the present invention also concerns data storage and/or processing devices based on ferroelectric thin films.

No prior art of direct relevance regarding braiding/folding as taught in the present invention has been identified. However, a brief general background shall be given to illustrate the present state of the art, put the present invention into context and highlight the objects of the invention:

Memory chips have the advantage over conventional magnetic, optical and other mechanical storage devices of being capable of very fast read and write operations. Furthermore, they are solid state, have reasonably low power consumption and may offer high transfer speeds. The disadvantage is their limited capacity to store information, and a relatively high production cost relative to the storage capacity. Due to scaling problems and limited area, typically restricted to less than 1 cm²/chip, this situation is not likely to be much altered in the foreseeable future.

A solid state memory concept which circumvents the limitations described above has been developed based on hybrid silicon/polymer chips. The approach includes stacking thin layers of polymeric memory films on silicon substrates and accessing the passively addressed memory layers via the substrate circuitry. The problem with this solution, however, is that the number of memory layers in the stack typically is limited to 8 - 16 layers. Increasing this number is technically possible, but generally not practically viable for most mass market applications. Negative factors in this connection include extra overhead and real estate costs for driver circuitry (decoders and sense amplifiers in particular); reduced yield due to increased number of processing steps; problems associated with planarization when the number of memory layers becomes larger then the range mentioned; and a larger number of processing steps increasing the risk that underlying polymer layers are negatively affected, with a reduced functionality as a result.

There is also an unbalance in the hybrid memory concept to the extent that producing the silicon part is complex and requires advanced (albeit standard) fabrication processing, while building the memory stack in itself is a very simple low cost procedure, which potentially could be done outside fabrication facility, with non-lithographic tools. However, when these stacks are built on silicon the factors listed above combine to make this more costly and capacity limiting than desirable, e.g. it does become more cost-effective to use two or several chips to achieve the same capacity.

Also, the procedure used to deposit memory films on silicon is in practice limited to simple spin coating. This deposition technique has several advantages, but may also introduce unwanted side effects, like creating a larger than desirable internal stress, problems in controlling the film morphology and uniformity, etc. One procedure used to improve morphology is stretching of films, which cannot be applied in the hybrid case, another is to anneal films under high pressure which is not very applicable either (when spin coating and rigid substrates like silicon is used).

Because of the area restrictions related to a silicon-based device, the only feasible patterning approach is standard photomicrolithography i.e. providing a high resolution line pitch. This excludes low cost, non-lithographic patterning tools like inkjet printing and micropatterning.

Another problem related to the hybrid concept is packaging, especially soldering, which requires temperatures much higher than the melting temperature of polymers (more than 60°C higher). The polymer does not necessarily destruct when exposed to higher temperatures than its melting temperature, but a rework (reanneal) is required to bring back the film properties. More problematic is what happens to the electrode/film interface, which easily is destroyed when the polymer enters the liquid phase. This represents is substantial problem when multilayer stacks are involved.

Film properties are also seriously affected by electrode application, e.g. the top electrode deposition may have negative effects on the bottom electrode interface, e.g. by kicking off undesired ion transport, which may initiate a fatigue process in the polymer films. Morphological chain defects may also be induced.

In regard of the above-mentioned disadvantages, it is thus a first object of the present invention to provide novel architectures for solid state thin-film-based devices whereby the effective area available for data storage and/or processing can be made large through stacking of individual layers in a dense volumetric structure.

It is a second object of the present invention to prescribe how such stacking can be achieved in a practical manner while at the same time providing individual addressability for locations inside the stack through a limited number of electrical connections that are accessible from the outside of the stack.

It is a third object of the present invention to provide stacks containing a multiplicity of matrices, where each matrix contains a large number of thin-film cells that can be individually connected via passive matrix addressing.

It is a fourth object of the present invention to provide individual stacks in the form of modular units suitable for integration into devices with specialized functions and/or into larger units that add the capacities of two or more separate stacked units.

It is a fifth object of the present invention to apply the stacking concept to the manufacturing of data storage and/or processing devices that contain sub-units demanding mutually incompatible process steps.

The above objects as well as further features and advantages are realized with a memory device which according to the invention is characterized in that a stack of memory arrays is formed with two or more ribbon-like structures being folded and/or braided into each other, each ribbon-like structure comprising a flexible substrate of non-conducting material, that first and second electrode layers respectively, are provided on each surface of the substrate, such that the electrode layers each comprises the parallel stripe-like electrodes provided extending along the ribbon-like structure and a layer of memory material covers one of the electrode layers thereof and extends uninterrupted between the edges of the ribbon-like structure, that each memory array of the stack is formed by overlapping portions of a pair of adjacent ribbon-like structures folded and/or braided such that they cross in substantially orthogonal relationship, and that the word lines and the memory layer of a memory array in a stack are contained in the first ribbon-like structure of a pair of adjacent structures of this kind and the bit lines contained in the second ribbon-like structure thereof thereof.

Further features and advantages of the present invention are disclosed by the dependent claims.

The invention shall now be explained in greater detail with reference to preferred embodiments and the appended drawing figures, of which
fig. 1a shows a longitudinal cross-section of ribbon-like structure as used in the present invention,
fig. 1b a transversal cross-section thereof,
fig. 1c two ribbon-like structures crossing and contacting each other, forming a memory array in the overlap area,
fig. 2a an example of a stack of ribbon-like structures according to the invention,
fig. 2b an example of an embodiment of the present invention with two stacks similar to the one in fig. 2a,
figs. 3a, 3b cross sections of respectively the first and second stacks in fig. 2b,
fig. 4a schematically a ribbon-like structure with connection areas or contact fields on the front and back, and
fig. 4b how the ribbon-like structures may be provided to form stacked memory arrays according to another embodiment of the present invention.

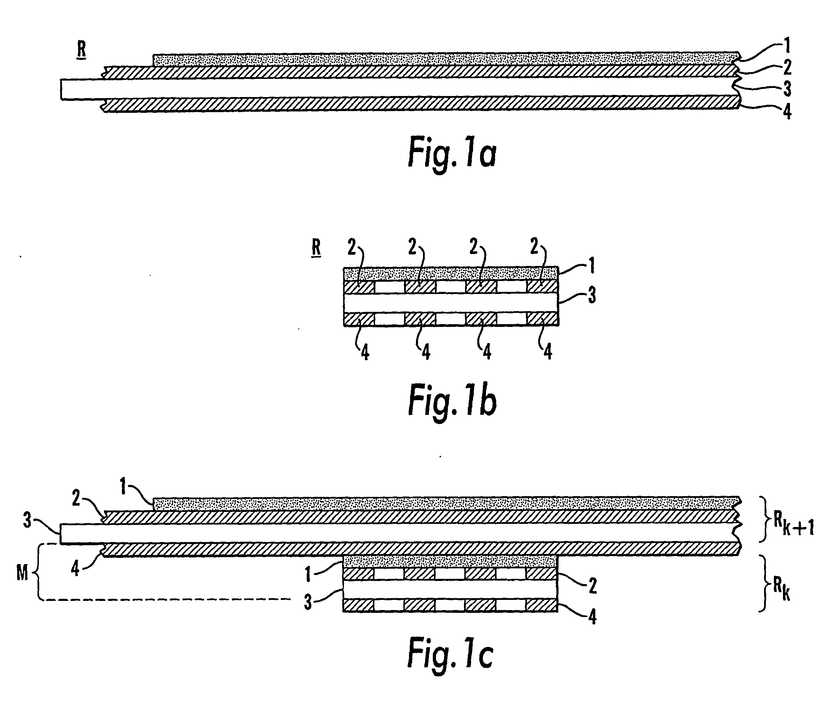

According to the invention, shown in figs. 1a and 1b, there is provided a ribbon with a carrier substrate 3 of a flexible material (e.g. polymer or metal) coated on one surface with a thin layer of memory film 1 on top of parallel electrodes 2 (in the longitudal direction), while the opposite surface of the ribbon either has a similar structure or a layer of parallel electrodes 4 only, the whole embodiment thus constituting a ribbon-like structure R (henceforth termed only as "ribbon") as used in the present invention.

The memory film 1 has addressing, charge storing (bistability) and/or switchability capabilities allowing memory matrices to be passively addressed and memory cells to be constituted by the memory film 1 being sandwiched between crossing electrodes 2;4 by a suitable arrangement of two or more ribbons contacting each other and oriented mutually at an angle of about 90°.

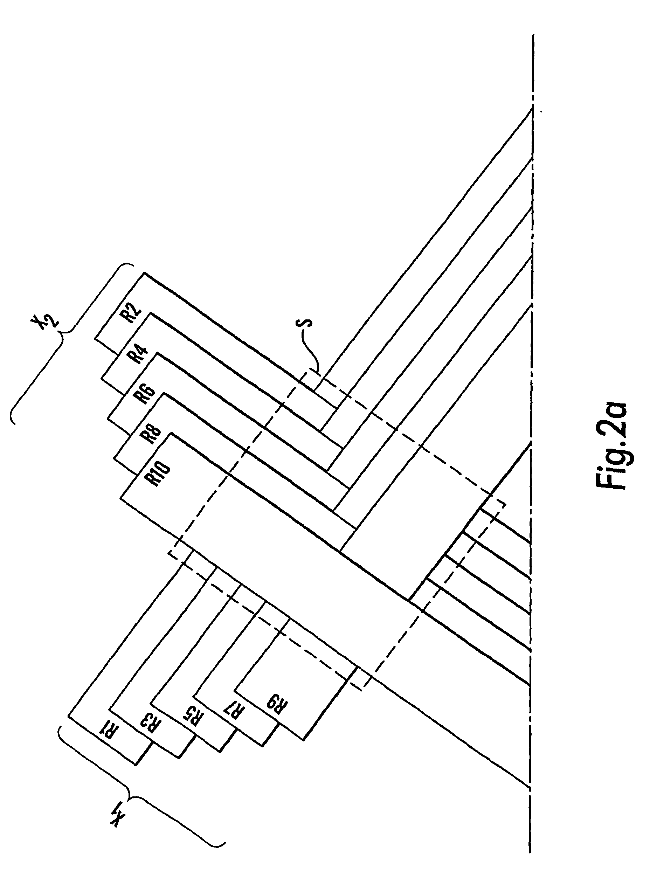

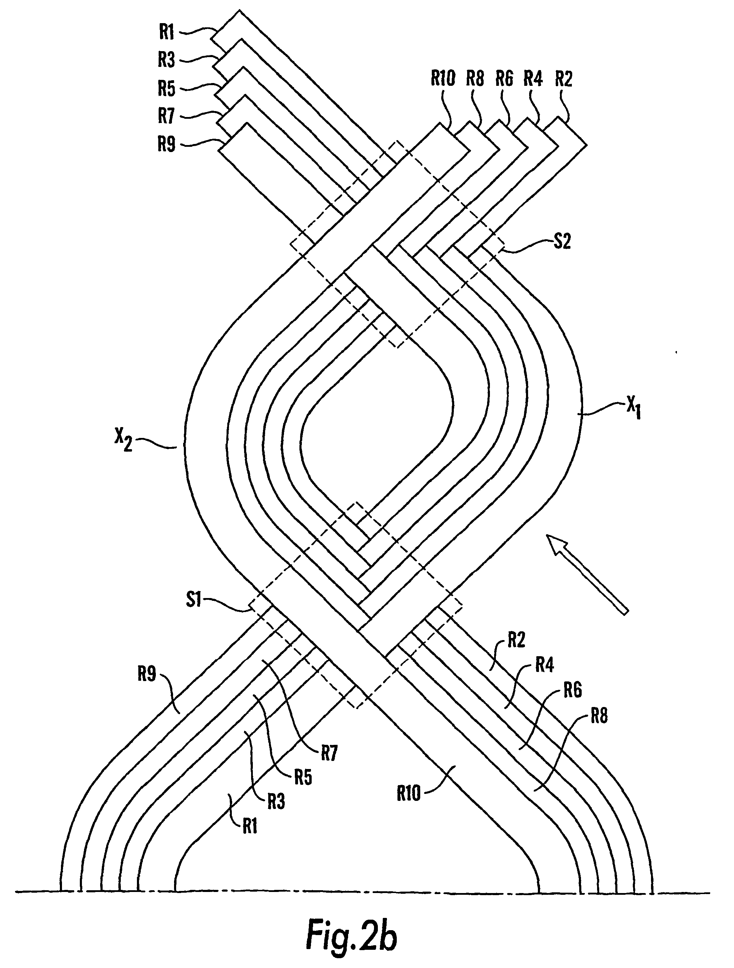

According to a preferred embodiment of the invention two or more ribbons R are stacked together, such that at each interface portion a memory array M is created in the adjoining ribbons and represented by top and bottom electrodes 2;4 and the memory film 1 in between. This is illustrated in fig.1c, showing a crossing between two ribbons Rₖ and Rₖ₊₁ which may constitute part of a larger stack. The ribbons R may have an arbitrary width and are mutually oriented in 90° angles with respect to each other such that the resulting stack has a square/cubic (chip-like) shape. Fig. 2a shows how ribbon R2 is stacked against ribbon R1, ribbon R3 against ribbon R2, and so forth, up to ribbon R10 stacked against ribbon R9.

In fig. 2a the odd-numbered ribbons R1,...R9 form a first subset or assembly X₁, the even-numbered ribbons R2,...R10 a second assembly X₂ oriented perpendicularly to the first. The resulting memory arrays form a stack S.

The ribbon overlaps are laminated together through an anneal process, e.g. under high vacuum/high pressure. By using a similar structure, i.e. memory film against memory film, compatibility problems related to the lamination process may be substantially reduced.

In an alternative embodiment the ribbons are folded according to a plurality of patterns, including concertina-wise, oval, circular/ring or twisted, as e.g. shown in fig. 2b. "Woven" threads may be made, which again can be used to make fabrics, etc. It will be possible to build large area structures in this way, thus enabling integration of memory into other devices, like into the casing of mobile phones, as a "top coating" on curved or other surfaces, etc.

The ribbons R1,...R9 arranged in a first subset or assembly X₁ and the ribbons R2,...R10 arranged in a second subset or assembly X₂ are applied in a memory device according to the invention. The embodiment of such a memory device as shown in fig. 2b forms two distinct stacked structures S 1, S2 as indicated by the boxes with stitched outlines. Each of the ribbons R1-R10 is bent such that pairs of odd and even numbered ribbons are permuted in the stack S2 with respect to the succession of ribbons in stack S1. This implies e.g. that the lowermost ribbon R9 in stack S1 is bent upwards to pair with the ribbon R10, while e.g. ribbon R1 which is paired with ribbon R10 in the stack S 1 now is bent downwards to pair with ribbon R2 in stack S2.

If the embodiment shown in fig. 2b is regarded as a plan view of the arrangement of the ribbons in the device according to the invention, it will by persons skilled in the art readily be understood that the combination of displacements and staggering shall provide a significant contribution with regard to minimizing capacitive crosstalk or other undesired couplings between the separate memory arrays M forming each stack. Not only can each individual memory cell in a memory array in a stack be addressed, i.e. written or read, without unwanted disturbances which seriously reduce the signal/noise ratio of e.g. an output signal, but in addition a parallel addressing of all memory cells in an array and if desired all memory arrays in a stack will be possible while simultaneously still keeping any disturbing influences at a minimum.

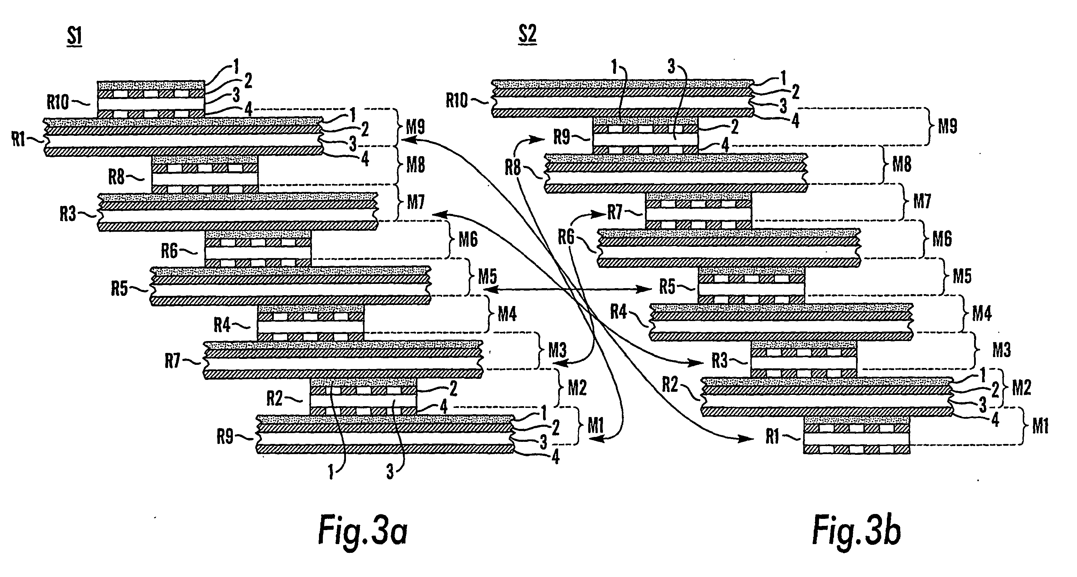

The arrangement of the stacks S1, S2 in the memory device according to the invention is shown to better advantage in cross sections in respectively figs. 3a, and 3b. In stack S1 (fig. 3a) the first ribbon R9 is provided orthogonally to the second ribbon R2 and second electrodes 2 in ribbon R9 now can be considered as word lines in a memory array M1 with the bit lines provided by the electrodes 4 in ribbon R2 and so on. In other words a memory array M comprises and is formed by a portion of respectively adjacent pairs of ribbons Rₖ, Rₖ₊₁ in a stack S. The stack S2 as shown in fig. 3b appears similar to the stack S1 in fig. 3a, but with the directions of adjacent pairs of ribbons R now rotated by 90° such that the orthogonal crossing between successive ribbons in the stack S2 is retained. It will be seen from fig. 2b that the first assembly X₁ of odd-numbered ribbons R1....R9 and the second assembly X₂ of even-numbered ribbons R2...R10 each could be followed by a similar adjacent assembly of ribbons provided in the lateral direction (i.e. in a side-by-side arrangement) with a corresponding orientation such that additional stacked structures S could be formed in the regions where the assemblies X₁, X₂ intersect. The additional assemblies of ribbons can also be provided in a staggered arrangement if so desired. Moreover it can also be seen from a contemplation of the arrangement in fig. 2b that the direction of staggering could inverted between neighbour stacks of memory arrays, i.e. for instance of ribbon R9 in stack S1 would still pair with ribbon R10 in stack S2, but now in the projected position of ribbon R1 in stack S2, while of course ribbon R1 then still would pair with ribbon R2 in stack S2, but now in the projected position as shown for ribbon 9 in fig. 2b, and so on. The implication of this is of course that similar considerations would also be applied to the stagger of the ribbons in the even-numbered assembly X₂ of ribbons R2,...R10. The distance as measured by the length of the electrodes 2,4 and ribbons R between the memory arrays M in one stack S 1 and the memory arrays M in the other stack S2 would then be similar.

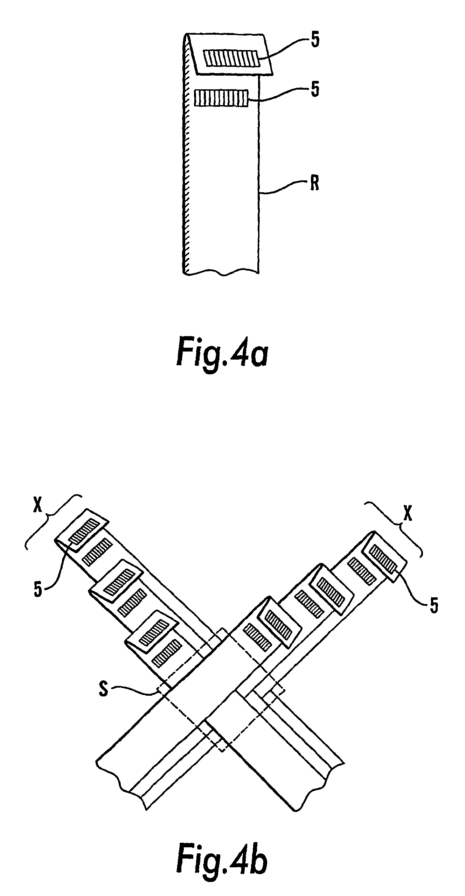

At the end of the ribbons R there can be provided connecting and contact means 5, as shown in figs. 4a and 4b. This would e.g. allow the electrodes 2,4 to be passively connected to pads on an underlying, not shown silicon chip, in which case sufficient redundancy is required to allow for a certain degree of misalignement. Alternatively or in addition there is provided for some (e.g. decoder/router) circuitry based on thin-film transistors (TFT) at the electrode ends, reducing the number of contacting points to facilitate a more robust connection. Such robustification may not only allow for a much denser electrode pattern, and thus increased storage density, but also allow folded (and packaged) memory stacks to be connected to the silicon chips (or pads connected to the silicon chip(s) by the end user, thus opening up for very low cost add-on memory modules.

A further enhancement of this concept would be to provide all driver circuitry, also including sensing circuitry, and required to operate the memory, at the ribbon ends. This would turn into the folded memory stack completely self-sustained unit.

Yet another enhancement would be to distribute the required circuitry evenly over the ribbons, directly in contact with (at the sides of) each individual memory matrix, as row and column drivers/decoders, and just contacting every one of these to a common bus/traffic coordinator on the ribbon(s) and then communicate with external hardware via hardwired or wireless contact(s).

When silicon or silicon/TFT circuitry on a supporting substrate is used, ribbon surfaces can be attached to silicon driver circuitry by bending one surface end over the other as shown in fig. 4b before attachment to contact pads on the underlying, not shown device substrate surface. If all driver circuitry is built on the ribbon(s) such bending is not required.

The resulting memory stack S built in this manner represents novel approaches and solutions to the problems discussed in the introduction. What basically takes place from an architectural standpoint is that because each memory array M is built on an individual substrate, the challenges are mostly reduced to those related to building single layer memories. This shall involve simple modular sub-units represented by the individual ribbons, which can be manufactured in specialized manufacturing equipment before being assembled in scalable fashion into stacks.

The concept allows the use of a very large number of stackable memory ribbons, the only restriction being access to silicon real estate in the silicon or hybrid silicon/TFT circuitry case, a restriction which does not exists in the "all circuitry on the ribbon (all-TFT)" case. This translates directly into a very large storage capacity, or arbitrarily large storage capacity in the all-TFT cases.

Because the approach is close to processing a single layer memory, most, if not all, the process and temperature compatibility issues related to multilayer processing vanish.

Similarly, by avoiding the deposition of top electrodes directly onto the memory films, possible negative effects of such procedure can also be avoided. A further positive effect on film morphology is the possibility to utilize stretching of the films before baking, thus ensuring a more orderly crystalline structure. Alternative deposition techniques to spin coating, like dip-coating/doctor blading/meniscus coating, may also have positive influence on film morphology.

Because the available area is large, a much more relaxed patterning process can be implemented, allowing non-lithographic tools and true reel-to-reel processing to be realised. This in its turn appreciably shall reduce the production costs.

The large feature sizes that can be utilized will also improve the signal/noise ratios with respect to cell signals, simply because cell sizes are so much larger. This will allow more variation in film thickness etc., thus reducing potential problems related to processing memory structures on flexible substrates.

High temperature packaging is facilitated in cases where devices are built on silicon chips, since the silicon part can be processed and soldered before the polymer is attached.

## Claims

1. A ferroelectric or electret volumetric memory device, wherein a ferroelectric or electret memory material (1) is provided in sandwich between first and second electrode layers (2;4) respectively comprising first and second parallel stripe-like electrodes forming word lines (2a) and bit lines (4a) of a matrix-addressable memory array (M), wherein word lines (2) and bit lines (4) of the array (M) are oriented substantially at right angles to each other, wherein memory cells are defined in volumes of memory material (1) sandwiched between respective crossing word lines (2) and bit lines (4), and wherein a plurality of memory arrays are provided in at least one stack (S) such that the at least one stack of memory arrays realizes the memory device with a volumetric configuration,
**characterized in that** a stack (S) of memory arrays (M) is formed with two or more ribbon-like structures (R) being folded and/or braided into each other, each ribbon-like structure (R) comprising a flexible substrate (3) of non-conducting material, that first and second electrode layers (2:4) respectively are provided on each surface of the substrate, such that the electrode layers (2,4) each comprise parallel stripe-like electrodes (2a,4a) provided extending along the ribbon-like structure (R) and a layer of memory material (1) covers one of the electrode layers thereof and extends uninterrupted between the edges of the ribbon-like structure, that each memory array (M) of the stack (S) is formed by overlapping portions of a pair of adjacent ribbon-like structures (R) folded and/or braided such that they cross in substantially orthogonal relationship, and that the word lines (2a) and the memory layer (1) of a memory array (M) in a stack (S) are contained in the first ribbon-like structure (R) of a pair of adjacent structures of this kind and the bit lines (4a) contained in the second ribbon-like structure (R) thereof.

2. A ferroelectric or electret volumetric memory device according to claim 1, **characterized in** every second memory array (M) of a stack (S) being provided in a mutually staggered arrangement.

3. A ferroelectric or electret volumetric memory device according to claim 1 wherein more than one stack (S) is provided, **characterized in that** the ribbon-like structures (R) are folded and/or braided in manner so as to realize a pair-wise permutation of the succession of ribbon-like structures from stack to stack.

4. A ferroelectric or electret volumetric memory device according to claim 1, **characterized in that** the ribbon-like structures (R) are arranged in two or more subsets (X) thereof, with the ribbon-like structures (R) in each given being oriented parallel to each other as viewed from the top of the stacks, and non-parallel to ribbon-like structures (R) in other different subsets.

5. A ferroelectric or electret volumetric memory device according to claim 4, **characterized in that** at least one ribbon-like structure (R) from each of at least two subsets (X) is provided with longitudinal electrodes (2;4) on one side and a global memory layer (1) on the other.

6. A ferroelectric or electret volumetric memory device according to claim 4, **characterized in that** the number of ribbon-like structures (R) and subsets (X) thereof are selected to minimize the length of the ribbon-like structures (R) compatible with a given functionality of the stack (S).

7. A ferroelectric or electret volumetric memory device according to claim 1, **characterized in that** each of the ribbon-like structures (R) has been pre-formed and prepared with insulating and/or conducting and/or semiconducting layers and structures in its cross section and/or on one or both of its surfaces.

8. A ferroelectric or electret volumetric memory device according to claim 1, **characterized in that** two or more ribbon-like structures (R) in the stack (S) have one set of electrodes (2a;4a) on one or both sides of the ribbon-like structures and extending the length of the ribbon-like structures.

9. A ferroelectric or electret volumetric memory device according to claim 8, **characterized in that** each electrode (2a;4a) is electrically accessed by being connected to a contacting field or area incorporating active and/or passive circuitry at or near one or both ends of the ribbon-like structures (R), said contacting fields in turn being connected electrically or optically to circuitry external to ribbon-like structures (R).

10. A ferroelectric or electret volumetric memory device according to claim 1, **characterized in that** the stack (S) contains at least two different types of ribbon-like structures (R).

11. A ferroelectric or electret volumetric memory device according to claim 1, **characterized in that** at least one ribbon-like structure (R) in the stack (S) has a global insulating layers on one or both of its surfaces.

12. A ferroelectric or electret volumetric memory device according to claim 1, **characterized in that** at least one ribbon-like structure (R) in the stack (S) has a length which is different from the other ribbon-like structure (R), in the stack (S).

## Patentansprüche

1. Volumetrisches ferroelektrisches bzw. Elektret-Speicherbauelement, bei welchem ein ferroelektrisches bzw. Elektret-Speichermaterial (1) in Sandwichbauweise zwischen ersten und zweiten Elektrodenschichten (2; 4) vorgesehen ist, die jeweils erste und zweite parallele streifenförmige Elektroden aufweisen, welche Wortzeilen (2a) und Bitzeilen (4a) einer nach Art einer Matrix adressierbare Speicheranordnung (M) bilden, wobei Wortzeilen (2) und Bitzeilen (4) der Speicheranordnung (M) im Wesentlichen rechtwinklig zueinander ausgerichtet sind und wobei Speicherzellen in Volumenbereichen des in Sandwich-Bauweise zwischen jeweiligen sich überkreuzenden Wortzeilen (2) und Bitzeilen (4) angeordneten Speichermaterials (1) definiert sind, und bei welchem eine Vielzahl von Speicheranordnungen in mindestens einem Stapel (S) in der Weise vorgesehen ist, dass der mindestens eine Stapel Speicheranordnungen das Speicherbauelement mit volumetrischer Konfiguration realisiert,
**dadurch gekennzeichnet, dass** ein Stapel (S) aus Speicheranordnungen (M) mit zwei oder mehr bandförmigen Strukturen (R) gebildet ist, welche dabei ineinander gefaltet und/oder geflochten sind, wobei jede bandförmige Struktur (R) ein biegsames Substrat (e) aus nicht-leitendem Werkstoff aufweist, dass erste und zweite Elektrodenschichten (2; 4) jeweils auf jeder Fläche des Substrats in der Weise vorgesehen sind, dass die Elektrodenschichten (2, 4) jeweils parallele streifenförmige Elektroden (2a, 4a) aufweisen, die in der Form vorgesehen sind, dass sie sich entlang der bandförmigen Struktur (R) erstrecken und eine Lage aus Speichermaterial (1) eine der Elektrodenschichten derselben überdeckt und sich ohne Unterbrechung zwischen den Kanten der bandförmigen Struktur erstreckt, dass jede Speicheranordnung (M) des Stapels (S) von sich überdeckenden Bereichen eines Paares benachbarter bandförmiger Strukturen (R) gebildet ist, welche in der Weise gefaltet und/oder geflochten sind, dass sie sich in einer im Wesentlichen senkrechten Beziehung überkreuzen und dass die Wortzeilen (2a) und die Speicherschicht (1) einer Speicheranordnung (M) in einem Stapel (S) in der ersten bandförmigen Struktur (R) eines Paares benachbarter Strukturen dieser Art enthalten sind und dass die Bitzeilen (4a) in dessen zweiter bandförmiger Struktur (R) enthalten sind.

2. Volumetrisches ferroelektrisches bzw. Elektret-Speicherbauelement nach Anspruch 1, **dadurch gekennzeichnet, dass** in jeder zweiten Speicheranordnung (M) eines Stapels (S) eine gegenseitig versetzte Anordnung vorgesehen ist.

3. Volumetrisches ferroelektrisches bzw. Elektret-Speicherbauelement nach Anspruch 1, bei welchem mehr als ein Stapel (S) vorgesehen ist,
**dadurch gekennzeichnet, dass** die bandförmigen Strukturen (R) in der Weise gefaltet und/oder geflochten sind, dass eine paarweise Permutation der Abfolge der bandförmigen Strukturen von Stapel zu Stapel gebildet wird.

4. Volumetrisches ferroelektrisches bzw. Elektret-Speicherbauelement nach Anspruch 1, **dadurch gekennzeichnet, dass** die bandförmigen Strukturen (R) in zwei oder mehr Teilmengen (X) derselben angeordnet sind, wobei die bandförmigen Strukturen (R) in jeder Teilmenge bei Blickrichtung vom oberen Teil des Stapels aus parallel zueinander ausgerichtet sind, sowie nicht parallel zu bandförmigen Strukturen (R) in anderen davon verschiedenen Teilmengen.

5. Volumetrisches ferroelektrisches bzw. Elektret-Speicherbauelement nach Anspruch 4, **dadurch gekennzeichnet, dass** mindestens eine bandförmige Struktur (R) aus jeder der mindestens zwei Teilmengen (X) mit in Längsrichtung verlaufenden Elektroden (2; 4) auf einer Seite und eine globale Speicherschicht (1) auf der anderen Seite angeordnet sind.

6. Volumetrisches ferroelektrisches bzw. Elektret-Speicherbauelement nach Anspruch 4, **dadurch gekennzeichnet, dass** die Anzahl der bandförmigen Strukturen (R) und von deren Teilmengen (X) so gewählt ist, dass die Länge der bandförmigen Strukturen (R) auf ein Mindestmaß verringert wird, das mit einer vorgegebenen Funktionalität des Stapels (S) kompatibel ist.

7. Volumetrisches ferroelektrisches bzw. Elektret-Speicherbauelement nach Anspruch 1, **dadurch gekennzeichnet, dass** jede der bandförmigen Strukturen (R) vorgeformt und mit isolierenden und/oder leitfähigen Schichten und/oder Halbleiterlagen und Strukturen in seinem Querschnitt und/oder auf einer oder beiden ihrer Oberflächen zugerichtet wurde.

8. Volumetrisches ferroelektrisches bzw. Elektret-Speicherbauelement nach Anspruch 1, **dadurch gekennzeichnet, dass** zwei oder mehr bandförmige Strukturen (R) in dem Stapel (S) einen Satz Elektroden (2a; 4a) auf einer oder beiden Seiten der bandförmigen Strukturen aufweisen und die Länge der bandförmigen Strukturen verlängern.

9. Volumetrisches ferroelektrisches bzw. Elektret-Speicherbauelement nach Anspruch 8, **dadurch gekennzeichnet, dass** der elektrische Zugriff auf jede Elektrode (2a; 4a) **dadurch** erfolgt, dass sie mit einem Kontaktfeld bzw. einer Kontaktfläche verbunden ist, in welcher aktive und/oder passive Schaltungen an oder nahe einem oder beiden Enden der bandförmigen Strukturen (R) einbezogen sind, wobei die Kontaktfelder ihrerseits elektrisch oder optisch mit Schaltungen außerhalb der bandförmigen Strukturen (R) verbunden sind.

10. Volumetrisches ferroelektrisches bzw. Elektret-Speicherbauelement nach Anspruch 1, **dadurch gekennzeichnet, dass** der Stapel (S) mindestens zwei unterschiedliche Arten von bandförmigen Strukturen (R) enthält.

11. Volumetrisches ferroelektrisches bzw. Elektret-Speicherbauelement nach Anspruch 1, **dadurch gekennzeichnet**, mindestens eine bandförmige Struktur (R) in dem Stapel (S) eine globale Isolierschicht auf einer Oberfläche oder auf beiden Flächen aufweist.

12. Volumetrisches ferroelektrisches bzw. Elektret-Speicherbauelement nach Anspruch 1, **dadurch gekennzeichnet, dass** mindestens eine bandförmige Struktur (R) in dem Stapel (S) eine Länge besitzt, die sich von der Länge der anderen bandförmigen Struktur (R) in dem Stapel (S) unterscheidet.

## Revendications

1. Dispositif de mémoire volumétrique ferroélectrique ou à électret, dans lequel un matériau pour mémoire ferroélectrique ou à électret (1) est pris en sandwich entre une première et une seconde couches d'électrodes (2 ; 4) comprenant respectivement une première et une seconde électrode parallèles de type bandes formant des lignes de mots (2a) et des lignes de bits (4a) d'un réseau de mémoire adressable par matrice (M), dans lequel lesdites lignes de mots (2) et lignes de bits (4) du réseau (M) sont orientées essentiellement à angle droit l'une par rapport à l'autre, dans lequel des cellules de mémoire sont formées dans des volumes du matériau pour mémoire (1) en sandwich entre les lignes de mots (2) et les lignes de bits (4) respectives qui se croisent, et dans lequel plusieurs réseaux de mémoire sont disposés en au moins une pile (S) de sorte que ladite et au moins une pile de réseaux de mémoire forme un dispositif de mémoire ayant une configuration géométrique, **caractérisé en ce qu'**une pile (S) de réseaux de mémoire (M) comporte deux structures de type ruban (R) ou plus qui sont pliées et/ou tressées l'une dans l'autre, chaque structure de type ruban (R) comprenant un substrat flexible (3) fait d'un matériau non conducteur, **en ce que** les première et seconde couches d'électrodes (2 ; 4) se situent respectivement sur chaque surface du substrat de sorte que les couches d'électrodes (2, 4) comprennent chacune des électrodes de type bandes parallèles (2a, 4a) qui s'étendent le long de la structure de type ruban (R) et qu'une couche de matériau pour mémoire (1) recouvre une de ses couches d'électrodes et s'étende de manière ininterrompue entre les bords de la structure de type ruban, **en ce que** chaque réseau de mémoire (M) de la pile (S) est formé en faisant se chevaucher des parties d'une paire de structures de type ruban (R) pliées et/ou tressées de sorte qu'elles se croisent essentiellement selon une relation orthogonale, et **en ce que** les lignes de mots (2a) et la couche de mémoire (1) d'un réseau de mémoire (M) dans une pile (S) sont contenues dans une première structure de type ruban (R) appartenant à une paire de structures adjacentes de ce type tandis que les lignes de bits (4a) sont contenues dans la seconde structure de type ruban (R) de ce type.

2. Dispositif de mémoire volumétrique ferroélectrique ou à électret selon la revendication 1, **caractérisé en ce que** chaque second réseau de mémoire (M) d'une pile (S) est disposé selon un agencement en quinconce par rapport aux autres.

3. Dispositif de mémoire volumétrique ferroélectrique ou à électret selon la revendication 1, dans lequel on utilise plus d'une pile (S) et **caractérisé en ce que** les structures de type rubans (R) sont pliées et/ou tressées de manière à réaliser une permutation de type paire de la succession de structures de type rubans d'une pile à l'autre.

4. Dispositif de mémoire volumétrique ferroélectrique ou à électret selon la revendication 1, **caractérisé en ce que** les structures de type rubans (R) sont réparties en deux sous-ensembles (x) ou plus, les structures de type rubans (R) dans chacun d'eux étant parallèles les unes aux autres telles que vues depuis le dessus des piles mais n'étant pas parallèles aux structures de type rubans (R) des autres sous-ensembles différents.

5. Dispositif de mémoire volumétrique ferroélectrique ou à électret selon la revendication 4, **caractérisé en ce qu'**au moins une structure de type ruban (R) de chacun desdits et au moins deux sous-ensembles (X) comporte des électrodes longitudinales (2 ; 4) sur un côté et une couche de mémoire globale (1) sur l'autre.

6. Dispositif de mémoire volumétrique ferroélectrique ou à électret selon la revendication 4, **caractérisé en ce que** les nombres de structures de type rubans (R) et de sous-ensembles (X) de ces dernières sont choisis de manière à minimiser la longueur des structures de type rubans (R) compatibles avec une fonctionnalité donnée de la pile (S).

7. Dispositif de mémoire volumétrique ferroélectrique ou à électret selon la revendication 1, **caractérisé en ce que** chacune des structures de type rubans (R) a été préformée et préparée à l'aide de couches et de structures isolantes et/ou conductrices et/ou semi-conductrices dans sa section transversale et/ou sur une ou sur ses deux surfaces.

8. Dispositif de mémoire volumétrique ferroélectrique ou à électret selon la revendication 1, **caractérisé en ce que** deux structures de type rubans (R) ou plus dans la pile (S) comportent un ensemble d'électrodes (2a ; 4a) situé sur un côté ou sur les deux côtés des structures de type rubans et s'étendant sur la longueur des structures de type rubans.

9. Dispositif de mémoire volumétrique ferroélectrique ou à électret selon la revendication 8, **caractérisé en ce que** chaque électrode (2a ; 4a) est électriquement accessible **en ce qu'**elle est connectée à un champ ou une zone de contact comportant un circuit actif et/ou passif au niveau ou à proximité d'une ou des deux extrémités des structures de type rubans (R), lesquels champs de contact sont à leur tour connectés électriquement ou optiquement à un circuit extérieur aux structures de type rubans (R).

10. Dispositif de mémoire volumétrique ferroélectrique ou à électret selon la revendication 1, **caractérisé en ce que** la pile (S) contient au moins deux types différents de structures de type rubans (R).

11. Dispositif de mémoire volumétrique ferroélectrique ou à électret selon la revendication 1, **caractérisé en ce qu'**au moins une structure de type ruban (R) de la pile (S) possède des couches isolantes globales sur une surface ou sur ses deux surfaces.

12. Dispositif de mémoire volumétrique ferroélectrique ou à électret selon la revendication 1, **caractérisé en ce qu'**au moins une structure de type ruban (R) de la pile (S) possède une longueur qui est différente de l'autre structure de type ruban (R) de la pile (S).
